Europäisches Patentamt

European Patent Office

Office européen des brevets

(11) Veröffentlichungsnummer: **0 185 244**
**A1**

(12) # EUROPÄISCHE PATENTANMELDUNG

(21) Anmeldenummer: 85115331.2

(22) Anmeldetag: 03.12.85

(51) Int. Cl.⁴: **H 01 L 23/14**
H 01 L 23/36, H 01 L 21/58
H 01 L 25/16

(30) Priorität: 07.12.84 DE 3444699

(43) Veröffentlichungstag der Anmeldung:
25.06.86 Patentblatt 86/26

(84) Benannte Vertragsstaaten:
DE FR GB IT

(71) Anmelder: TELEFUNKEN electronic GmbH
Theresienstrasse 2
D-7100 Heilbronn(DE)

(72) Erfinder: Kilian, Hermann, Dipl.-Ing.
An der Strut 3
D-8531 Diespeck(DE)

(74) Vertreter: Maute, Hans-Jürgen, Dipl.-Ing.
TELEFUNKEN electronic GmbH Theresienstrasse 2
D-7100 Heilbronn(DE)

(54) Elektrisches Leistungsbauteil.

(57) Ein elektrisches Leistungsbauteil weist ein elektrisches Leistungselement 1 auf, das mit einem Kühlkörper 6 verbunden ist. Um hierbei mit einfachen Mitteln und bei geringer mechanischer wie thermischer Belastung eine elektrisch isolierende und einen guten Wärmedurchgangswert aufweisende Verbindung zwischen dem Kühlkörper 6 und dem Leistungselement 1 zu erreichen, ist das Leistungselement 1 auf den Kühlkörper 6 mittels eines Silikonklebers aufgeklebt. Der Silikonkleber wird anschließend in einer thermischen Behandlung zu einer dauerelastischen Schicht ausgehärtet.

Fig.1

0185244

TEG-84/05                                              4.12.1984

TELEFUNKEN electronic GmbH
Theresienstraße 2
7100 Heilbronn

### Elektrisches Leistungsbauteil

Die Erfindung betrifft ein elektrisches Leistungsbauteil gemäß dem Oberbegriff des Anspruchs 1.

Es ist bei elektrischen Leistungsbauteilen ganz allgemein bekannt, ein Leistungselement in Form eines chipförmigen Transistors auf einen Kühlkörper aufzulöten. Hierzu ist es erforderlich, bei nicht metallischen Kühlkörpern eine Metallisierung z.B. durch stromlose Nickel-Abscheidung vorzusehen, von der anschließend durch selektives Abätzen nur der Teil verbleibt, auf den der Transistor aufgelötet werden soll. Das Auflöten erfolgt dabei mit einem Lot ohne Flußmittel, wobei relativ hohe Temperaturen von etwa 350°C erforderlich sind. Derartige Lötvorgänge können nur in reduzierender Atmosphäre vorgenommen werden, die aus einem Gemisch von Stickstoff und Wasserstoff besteht. Abgesehen von der Gefährdung des Halbleiterbauteils durch die hohe Temperatur ist das Auflöten mit aufwendigen Verfahrensschritten und Herstellungseinrichtungen verbunden. Der Herstellungsprozeß ist dabei auch sehr unflexibel. Außerdem kann nur eine begrenzte Auswahl von Materialpaarungen angewandt werden.

Der Erfindung liegt die Aufgabe zugrunde, ein elektrisches Leistungsbauteil gemäß dem Oberbegriff des Anspruchs 1 zu schaffen, das mit einfachen Mitteln und problemlosen Herstellungsschritten die Fertigung einer elektrischen Isolation bei gutem Wärmeübergangswert zwischen dem Leistungselement und dem Kühlkörper ermöglicht.

Die Lösung dieser Aufgabe erfolgt gemäß der Erfindung durch die kennzeichnenden Merkmale des Anspruchs 1.

Durch das gemäß der Erfindung vorgesehene Aufkleben des Leistungselementes auf den Kühlkörper wird eine elektrisch isolierende und thermisch gut leitende, hochflexible Verbindung mit guten Festigkeitswerten für viele Materialien erhalten. Als Material eignet sich dabei insbesondere Aluminium, das auch eloxiert sein kann, Kupfer, Nickel, Edelstahl, Glas, alle Arten von Keramik, duroplastische Kunststoffe und Thermoplaste, wie Polyester und Polyamid, wenn als Kleber ein Silikonpolymer mit eingebautem Haftvermittler und gut wärmeleitendem Füllstoff ohne Lösungsmittel angewandt wird. Eine so ausgeführte Klebeverbindung weist auch nach scharfen Temperaturwechselzyklen eine einwandfreie Haftung und einen unverändert guten Wärmeübergang zwischen dem Leistungselement und dem Kühlkörper auf. Diese gute Temperaturwechselbeständigkeit bleibt auch für relativ große Kontaktflächen von beispielsweise 20 x 40 mm erhalten. Die erreichbaren Wärmewiderstände liegen dabei im Bereich einer gelöteten Ausführung.

Bei der Herstellung eines so aufgebauten elektrischen Leistungsbauteils wird auf einen Oberflächenabschnitt des Kühlkörpers oder des Leistungselementes eine Schicht des Klebers aufgetragen und anschließend der Kühlkörper und das Leistungssteuerelement unter Druck zusammengefügt sowie in fixierter Lage zueinander gehalten. Anschließend wird die so gebildete Einheit einer thermischen Behandlung unterzogen, wobei der Kleber zu einer hochflexiblen Schicht aushärtet. Eine Klebeverbindung dieser Art und ihre Durchführung erfordern keine speziellen, insbesondere keine explosionsgeschützten Fertigungseinrichtungen.

3

0185244

Vorteilhafte Ausgestaltungen der Erfindung sind in weiteren Ansprüchen angegeben.

Die Erfindung ist nachfolgend anhand der Zeichnungen von Ausführungsbeispielen näher erläutert.

Es zeigt:

Figur 1    ein Leistungsbauteil mit einem auf einen metallischen Kühlkörper aufgeklebten Leistungselement und

Figur 2    ein Leistungsbauteil mit einem auf eine Hybridschaltung aufgeklebten Leistungselement.

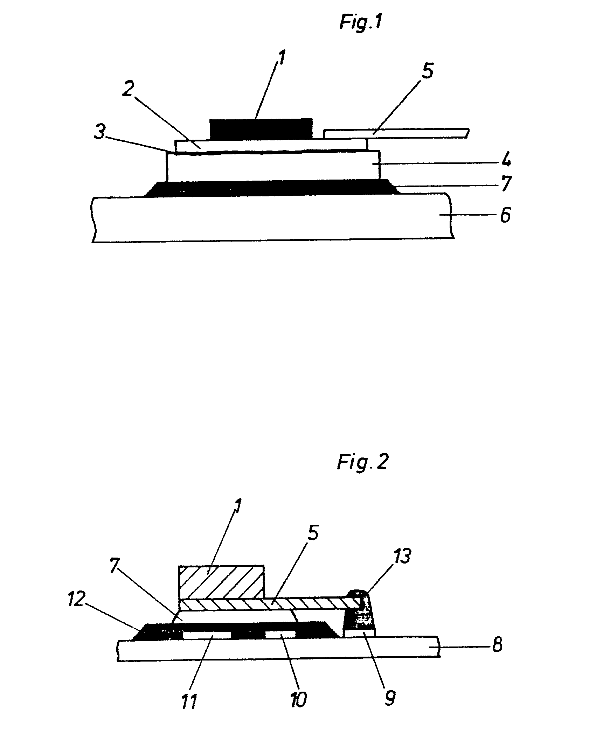

Gemäß Figur 1 ist ein chipförmiges Leistungselement 1, vorzugsweise ein Leistungstransistor, herstellerseitig mittels eines Lotes 2 auf eine Metallisierung 3 einer elektrisch isolierenden, aber gut wärmeleitenden Keramikscheibe 4 aufgelötet. Mit dem Lot 2 ist gleichzeitig ein Anschlußdraht 5 auf die Metallisierung 3 aufgelötet. Um das in dieser Weise vorgefertigte Leistungselement mit geringem Wärmeübergangswiderstand auf einfache Weise mit einem Kühlkörper 6 zu verbinden, ist zwischen die Keramikscheibe 4 und den Kühlkörper 6 eine Schicht 7 aus einem elektrisch isolierenden, und thermisch gut leitenden, im ausgehärteten Zustand hochflexiblen Kleber vorgesehen. Die Schicht 7 besteht dabei vorzugsweise aus einem lösungsmittelfreien Silikonpolymer mit eingebautem Haftvermittler und gut wärmeleitendem Füllstoff. Dieser Silikonkleber wird im Siebdruck- oder Stempelverfahren in definierter Stärke auf einen Oberflächenabschnitt des Kühlkörpers und/oder auf die gesamte, dem Kühlkörper 6 zugewandte Seitenfläche der Keramikscheibe 4 in flüssigem bzw. pastösem Zustand aufgetragen. Anschließend werden die beiden Teile 4, 6 mit ihren zu verklebenden Oberflächen unter definiertem Druck zusammengefügt und in der vorgesehenen Position für einen nachfolgenden Aushärtevorgang des Silikonklebers fixiert. Der Aushärtevorgang wird bei erhöhter Temperatur so lange ausgeführt, bis der Silikonkleber zu einer hochflexiblen Schicht 7 ausgehärtet ist.

Gemäß Figur 2 ist das Leistungselement 1 von einem Gehäuse umgeben, das an seiner Unterseite einen fest damit verbundenen Anschluß 5 aufweist. Daneben ist ein plattenförmiger Keramikträger 8 vorgesehen, auf den Leiterbahnen 9 und 10 sowie getrennt davon ein abgleichbarer Widerstand aufgedruckt sind. Zum Schutz des Widerstandes 11 und der Leiterbahn 10 gegen äußere Einflüsse ist der entsprechende Bereich des Keramikträgers 8 mit einer elektrisch isolierenden Passivierung 12 überdeckt, die einen luft- und feuchtigkeitsdichten Abschluß bildet. Auf diese Passivierung 12 ist das Gehäuse 1 bzw. der Anschluß 5 durch eine dazwischen angeordnete Schicht 7 verbunden, die in der gleichen Weise ausgebildet und hergestellt ist, wie sie zu Figur 1 bereits beschrieben wurde. Über diese Schicht 7 wird auch hier die vom Leistungselement 1 im Betrieb erzeugte Verlustwärme über die gut wärmeleitende Schicht 7 über die ebenfalls hoch wärmeleitende Passivierung 12 bzw. die Bauelemente 10, 11 auf den als Kühlkörper wirkenden Keramikträger 8 übertragen. Der Anschluß 5 ist im übrigen mittels eines Lottropfens 13 mit der Leiterbahn 9 verlötet.

Ein Leistungsbauteil gemäß Figur 1 ist besonders geeignet für Kraftfahrzeug-Zündschaltungen, in welchen ein NPN-Transistorchip mit einer Verlustleistung von etwa 50 Watt zur Anwendung kommt. Für weniger hoch belastete Abschnitte des Leistungsbauteils ist die Anordnung nach Figur 2 geeignet. In allen Fällen ergibt sich eine dauerhafte, gut wärmeleitende und elektrisch isolierende Haftverbindung die auch nach einer großen Zahl von scharfen Temperaturwechselzyklen im Temperaturbereich von minus 40°C bis plus 125°C in Zeitabständen von 10 Minuten keine mechanische Ablösung oder eine Veränderung der elektrischen oder thermischen Eigenschaften zeigt.

0185244

TELEFUNKEN electronic GmbH

Theresienstraße 2

7100 Heilbronn

**Ansprüche**

1. Elektrisches Leistungsbauteil mit einem elektrischen Leistungssteuerelement, das mit einem Kühlkörper verbunden ist, dadurch gekennzeichnet,
daß das Leistungssteuerelement (1) auf den Kühlkörper (6, 8) aufgeklebt ist
und insbesondere in Hybridschaltungen, z.B. KFZ-Zündschaltungen, Verwendung
findet.

2. Leistungsbauteil nach Anspruch 1, dadurch gekennzeichnet, daß zwischen
dem Leistungselement (1) und dem Kühlkörper (6, 8) eine Schicht (7) aus
einem Silikonkleber vorgesehen ist.

3. Leistungsbauteil nach Anspruch 2, dadurch gekennzeichnet, daß die Schicht
(7) ein lösungsmittelfreies Silikonpolymer mit eingebautem Haftvermittler und
gut wärmeleitendem Füllstoff ist.

4. Leistungsbauteil nach Anspruch 1 oder einem der folgenden, dadurch
gekennzeichnet, daß die Schicht (7) im Siebdruck- oder Stempelverfahren
wenigstens auf einen Oberflächenabschnitt des Kühlkörpers (6, 8) und/oder
des Leistungselementes (1) aufgetragen ist und somit eine definierte und
reproduzierbare Kleberdicke erzeugt wird.

5. Leistungsbauteil nach Anspruch 1 oder einem der folgenden, dadurch gekennzeichnet, daß das Leistungselement (1) ein Halbleiterchip ist, der auf eine metallisierte Keramikscheibe (4) aufgelötet ist und daß die dem Halbleiterchip abgewandte Seite der Keramikscheibe (4) auf den Kühlkörper (6) aufgeklebt ist.

6. Leistungsbauteil nach einem der Ansprüche 1 bis 5, dadurch gekennzeichnet, daß das Leistungselement (1) ein Gehäuse aufweist, daß auf einem elektrisch isolierenden keramischen Träger (8) Schichschaltungsbauelemente (9, 10, 11) aufgetragen sind, daß die Schichtschaltungsbauelemente mit einer isolierenden Passivierung (12) überzogen sind und daß das Gehäuse auf die Passivierung (12) aufgeklebt ist.

7. Verfahren zur Herstellung eines Leistungsbauteils nach Anspruch 1 oder einem der folgenden, dadurch gekennzeichnet, daß auf einen Oberflächenabschnitt des Kühlkörpers und/oder des Leistungselementes eine Schicht eines Klebers aufgetragen wird, daß der Kühlkörper und das Leistungselement anschließend unter Druck zusammengefügt und fixiert werden und daß anschließend die Einheit einer thermischen Behandlung unterzogen wird, wobei der Kleber zu einer hochflexiblen Schicht aushärtet.

Fig.1

Fig.2

## Europäisches Patentamt

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | EP-A-0 065 686 (GENERAL ELECTRIC) <br> * Anspruch 1 * | 1 | H 01 L 23/14 <br> H 01 L 23/36 <br> H 01 L 21/58 <br> H 01 L 25/16 |
| | --- | | |
| A | DE-U-7 822 999 (LICENTIA PATENT-VERWALTUNGS-GMBH) <br> * Seite 5, letzter Absatz - Seite 6, Absatz 1 * | 1,5,6 | |
| | --- | | |
| A | US-A-3 386 015 (T.H. RAMSEY) <br> * Spalte 2, Zeilen 29-50 * | 1-3,7 | |
| | --- | | |
| A | FEINWERKTECHNIK UND MESSTECHNIK, Band 92, Nr. 2, März 1984, Seiten 67-69, München; M. HOF "Klebetechniken in der Mikroelektronik" | 4 | |
| | ----- | | RECHERCHIERTE SACHGEBIETE (Int Cl 4) <br><br> H 01 L 21/58 <br> H 01 L 23/00 <br> H 01 L 25/16 |

Der vorliegende Recherchenbericht wurde für alle Patentansprüche erstellt

| Recherchenort <br> BERLIN | Abschlußdatum der Recherche <br> 10-03-1986 | Prüfer <br> GIBBS C.S. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82